# EUROPEAN PATENT APPLICATION

(11) **EP 1 211 800 A2**
(43) Date of publication of application: **05.06.2002**
(21) Application number: 01307529.6
(22) Date of filing: 05.09.2001
(51) Int. Cl.: H03C 1/36

(54) **Amplitude modulator using a bipolar transistor**

(30) Priority: 08.11.2000 IT TO001051
(71) Applicant: Marconi Communications SPA, 16153 Genoa (IT)
(72) Inventor: Carbonini, Lorenzo, 16032 Carmogli (GE) (IT)
(74) Representative: Hoste, Colin Francis

(57) **Abstract**

An amplifier apparatus 30 comprises a diode 31 and a transistor 35. In operation, a pulsed signal 57 is applied to the diode 31 and a modulating signal 45 is applied to the collector 40 of the transistor 45. A low level version of the modulating signal 45, as indicated by driving signal 49, serves to pilot the attenuation characteristics of the diode 31 such that it attenuates the pulsed signal 57 during its rising and falling periods in order to produce an attenuated signal 59.

Accordingly, when the current through the diode 31 is relatively high the diode 31 has low resistance and the signal 57 is not attenuated and when the current through the diode 31 is relatively low then the diode 31 exhibits a relatively higher resistance and the signal 57 is strongly attenuated.

## Description

The present invention relates to an attenuator and amplifier apparatus and to a communications systems including an attenuator and/or amplifier apparatus.

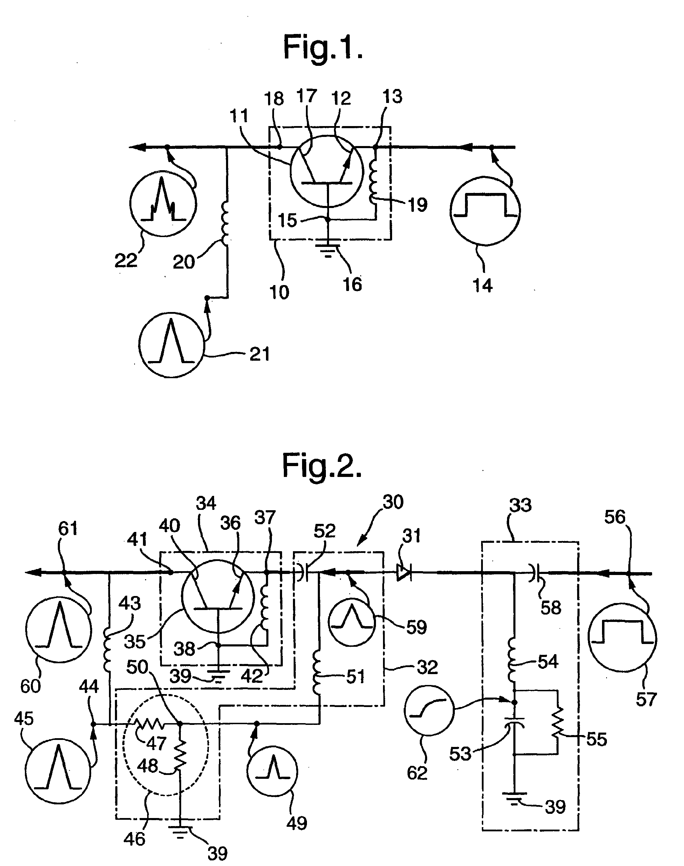

As shown in Figure 1, a conventional amplifier 10 comprises a NPN type transistor 11 having its emitter 12 connected to an input terminal 13 arranged to receive a pulsed input signal 14. The base 15 of the transistor 11 is connected to ground 16 and the collector 17 of the transistor 11 is connected to an output terminal 18. The transistor 11 also has an inductor 19 connected between the input terminal 13 and ground 16. A second inductor 20 is connected to the output terminal 13 and is arranged to receive a modulating signal 21 at one of its terminals and to convey the modulating signal 21 to the output terminal 13. It will be understood that the transistor 11 is arranged in a conventional C-class amplifier configuration for amplitude modulation.

In operation, a low level rectangular radio frequency pulsed input signal 14 is fed to the input terminal 13 of the amplifier 11 where it impinges on the emitter 12. The collector 17 of the transistor 11 is fed with a variable voltage modulating signal 21 through the second inductor 20 which serves to inhibit the pulsed input signal 14 from passing therethrough. The amplitude modulation product of the pulsed input signal 14 with the modulating signal 21 serves to generate a desired output radio frequency pulse in the form of modulated output signal 22 which has amplified power with respect to the pulsed input signal 14.

However, during the rising and/or falling durations of the modulated output signal 22 the voltage at the collector 17 of the transistor 11 is relatively low whilst the power of the pulsed input signal 14 is relatively high. As a consequence, during the rising and/or falling durations the transistor 11 is saturated which results in generating both parametric resonances with subsequent output spectrum degradation and/or in distortion of the modulated output signal 22.

It is an object of the present invention to obviate or mitigate the disadvantages associated with the prior art.

According to a first aspect of the present invention an attenuator comprises a diode having an electrical network connected to one terminal which in operation is arranged to vary the resistance of the diode presented to a pulsed signal applied to the other terminal of the diode and that passes through the diode, such that during the rising and falling periods of the pulsed signal the diode attenuates the power of the pulsed signal.

In this manner, when the output of the attenuator is connected to the input of an amplifier stage, the pulsed signal is attenuated by the diode during those periods when the amplifier stage would normally be saturated by an unattenuated pulsed signal. Typically, such saturation is a source of parametric and distortion problems associated with the amplifier stage.

According to another aspect of the invention amplifier apparatus comprise an attenuator stage comprising a diode having a first electrical network connected to one terminal and an amplifier stage having its input terminal connected to the other terminal of the diode, in operation the first network is arranged to vary the resistance of the diode which is applied to a pulsed signal that passes through the diode, such that during the rising and falling periods of the pulsed signal the diode attenuates the power of the pulsed signal.

In this manner, the pulsed signal is attenuated by the diode of the attenuator stage during those periods of the pulsed signal when the amplifier stage would normally be saturated by the power of an unattenuated pulsed signal. Typically, such saturation is a source of parametric and distortion problems associated with the amplifier stage.

Preferably, the first network and the diode may be arranged to attenuate frequencies greater than a predefined frequency value.

A modulation signal applied to the amplifier stage may be used to control the operation of the diode. Alternatively, a portion of a modulation signal applied to the amplifier stage may be used to control the operation of the diode. In this manner, the modulation signal applied to the amplifier stage or a portion thereof can be used to control the attenuation properties, that is the resistance, of the diode and hence the attenuation applied to a pulsed signal passing through the diode before it impinges on the amplifier stage. Accordingly, the diode can be controlled to attenuate the pulsed signal during periods when the amplifier stage would normally be saturated by an unattenuated signal. The modulation signal may be fed back through the first network to the diode. The amplifier stage may comprise a transistor having its emitter connected to an input terminal of the amplifier, its base connected to ground and its collector connected to an output terminal of the amplifier, the transistor may also have an inductor connected between the emitter of the transistor and ground. The modulation signal may be applied to the collector of the transistor.

As a further alternative, an independent signal may be used to control the operation of the diode.

The first network may comprise an inductor arranged to inhibit the pulsed signal impinging on the collector of the transistor.

The amplifier apparatus may include a second network connected to the other terminal of the diode, and the second network may be arranged to ensure substantially asymmetric attenuation characteristics of the diode during rising and falling portions of the pulsed signal. The second network may comprise a capacitor arranged to charge during a rising portion of the pulsed signal. Preferably, a resistor may be arranged in parallel with the capacitor, the resistor being arranged to ensure discharge of the capacitor at the end of each cycle of the pulsed signal. In this manner, as the pulsed signal falls the charge stored across the capacitor is released to reversibly polarise the diode. This feature enhances the performance of the diode and obviates distortion of an output modulated pulsed signal from the amplifier stage as it provides substantially asymmetric attenuation characteristics of the diode during rising and falling portions of the pulsed signal.

The second network may also comprises an inductor arranged to inhibit the pulsed signal from impinging on the capacitor.

The first network may comprise a first blocking capacitor arranged in series with the diode and the second network may comprise a second blocking capacitor arranged in series with the diode, the first and second blocking capacitors being arranged to isolate the diode from the amplifier stage during direct current or for frequencies below a predefined threshold frequency of the pulsed signal.

Preferably, the pulsed signal may be a radio frequency signal.

According to a further aspect of the invention a communications system has at least one remote unit and at least one base station arranged to communicate with each remote unit over a communication channel, the communication system comprises an attenuator in accordance with the invention.

According to another aspect of the invention a communications system has at least one remote unit and at least one base station arranged to communicate with each remote unit over a communication channel, the communications system comprises amplifier apparatus in accordance with the invention. It will be understood that the term communications systems also includes telemetry systems.

The invention will now be described, by way of example only, with reference to the accompanying drawings, in which:
Figure 1 illustrates amplifier apparatus according to the prior art, and
Figure 2 illustrates attenuator and amplifier apparatus according to the present invention.

Referring to Figure 2, amplifier apparatus 30 comprises an attenuator stage comprising a diode 31 having a first electrical network 32 connected to its anode terminal and a second electrical network 33 connected to its cathode terminal. The amplifier apparatus 30 also comprises an amplifier stage 34 comprising a NPN type transistor 35 having its emitter 36 connected to an input terminal 37 which is further connected via the first electrical network 32 to the anode of the diode 31. The base 38 of the transistor 35 is connected to ground 39 and the collector 40 of the transistor 35 is connected to an output terminal 41 of the amplifier stage 34. The transistor 35 also has an inductor 42 connected between the input terminal 37 and ground 39. Furthermore, a second inductor 43 is connected between the output terminal 41 and a modulating input terminal 44 and is arranged to convey a modulating signal 45 from the modulating input terminal 44 to the output terminal 41. It will be understood that the transistor 35 is arranged in a conventional C-class amplifier configuration.

The first electrical network 32 comprises a resistive partition 46 comprising first and second resistors 47 and 48 connected in series between the modulating input terminal 44 and ground 39. The first and second resistors 47 and 48 are arranged to allow a lower level version of the modulating signal 45 to pass, in this case indicated by signal 49. It will be understood that the signal 49 is tapped off from a terminal 50 between the first and second resistors 47 and 48. The terminal 50 is connected to the anode of the diode 31 via an inductor 51. The first electrical network 32 also comprises a first blocking capacitor 52 arranged in series between the anode of the diode 31 and the input terminal 37 of the transistor 35.

The second electrical network 33 comprises a capacitor 53 connected between the cathode of the diode 31 and ground 39. The capacitor 53 is connected to the cathode diode 31 via an inductor 54. Furthermore, the capacitor 53 is also connected in parallel with a resistor 55.

The cathode of the diode 31 is also connected to an apparatus input terminal 56 via a second blocking capacitor 58, the input terminal being arranged to receive a pulsed input signal 57. It will be understood that the pulsed input signal 57 is in this example is a radio frequency signal.

In operation, a low level rectangular radio frequency pulsed input signal 57 is applied to the input terminal 56 and passes through second blocking capacitor 58 to the anode of the diode 31. Furthermore, a modulating signal 45 is applied to modulating input terminal 44 and passes through second inductor 43 to impinge on the collector 40 of the transistor 45 via output terminal 41. The modulating signal 45 also passes through resistor partition 46 and through inductor 51 to impinge on the anode terminal of the diode 31 as a low level version of the modulating signal 45, in this case indicated by driving signal 49.

The driving signal 49 pilots the attenuation characteristics of the diode 31 such that it attenuates the pulsed input signal 57 during its rising and falling periods in order to produce an attenuated signal 59. The diode 31 insures that the attenuated signal 59 exhibits a similar shape to a modulated output signal 60 developed at an apparatus output terminal 61. Accordingly, when the current through the diode 31 is high the diode 31 has low series resistance and the pulsed input signal 57 is not attenuated by the diode 31. However, if the current through the diode 31 is low then the diode 31 exhibits a relatively higher series resistance and the pulsed input signal 57 is strongly attenuated. In this manner, the input power to the transistor 35 during the rise and fall fronts of the pulsed input signal 57 is reduced thereby avoiding parametric and distortion problems of the amplified modulated output signal 60.

Inductors 51 and 54 are arranged to allow the driving signal 49 to pass so as to operate the diode 31 in the desired manner and to charge the capacitor 53 whilst inhibiting the pulsed input signal 57 from impinging on the terminal 50 or the capacitor 53. Inductor 43 is arranged to allow the modulating signal 45 to pass so as to impinge on the collector 40 of the transistor 35 and modulate the attenuated signal 49 whilst inhibiting the modulated output signal 60 from impinging on the terminal , 44.

The first and second blocking capacitors 52 and 58 are arranged to isolate the diode 31 from the transistor 35 and the pulsed input signal 57, respectively, when the frequency of pulsed input signal 57 falls below a predefined threshold frequency and from the direct current component of the pulsed input signal 57. The upper limit of the predefined threshold frequency is the frequency of the low level rectangular radio frequency pulsed input signal 57 applied to the input terminal 56. However, for practical purposes, since the capacitors 52 and 58 have a relatively slow filtering roll off, the predefined threshold frequency is lower than the frequency of the pulsed input signal 57 to avoid possible attenuation of the desired pulsed input signal 57.

It has been determined that by using high values for the inductors 51 and 54 sufficient attenuation performance from the diode 31 is ensured during each rising front of the pulsed input signal 57. However, proper operation of the diode during 31 during each falling front of the pulsed input signal 57 cannot be guaranteed due to the energy already stored in the diode 31. So as to ensure proper operation of the diode 31 during each falling front of the pulsed input 57, the capacitor 53 is arranged to progressively charge as a consequence of the direct current during each corresponding rising front to produce a charging signal 62. As the value of the driving signal 49 decreases below the value of the charging signal 62 during each falling front of the pulsed input signal 57, the diode is reversibly polarised by the charging signal 62. Thus the attenuation characteristics of the diode 31 are enhanced and the distortion of the modulated output signal 60 is inhibited. That is the attenuation characteristics are substantially asymmetric during the rising and falling fronts of the pulsed input signal 57.

Resistor 55 is arranged to ensure that the capacitor 53 completely discharges during each consecutive pulse of the pulsed input signal 57.

In an alternative amplifier apparatus 30, the lower level version of the modulating signal 45, as indicated by signal 49, is not a derivation of the modulating signal 45 and can in fact be an independent signal. In this particular embodiment there will be no need for resistive partition 46 and the independent signal will be directly fed to the anode of the diode 31 through inductor 51.

## Claims

1. An attenuator, comprising
a diode having an electrical network connected to one terminal which in operation is arranged to vary the resistance of the diode presented to a pulsed signal applied to the other terminal of the diode and that passes through the diode, such that during the rising and falling periods of the pulsed signal the diode attenuates the power of the pulsed signal.

2. Amplifier apparatus, comprising
an attenuator stage comprising a diode having a first electrical network connected to one terminal, and
an amplifier stage having its input terminal connected to the other terminal of the diode,
in operation the first network is arranged to vary the resistance of the diode which is applied to a pulsed signal that passes through the diode, such that during the rising and falling periods of the pulsed signal the diode attenuates the power of the pulsed signal.

3. Amplifier apparatus, as in Claim 2, wherein the first network and the diode are arranged to attenuate frequencies greater than a predefined frequency value.

4. Amplifier apparatus, as in Claims 2 or 3, wherein a modulation signal applied to the amplifier stage is used to control the operation of the diode.

5. Amplifier apparatus, as in Claims 2 or 3, wherein a portion of a modulation signal applied to the amplifier stage is used to control the operation of the diode.

6. Amplifier apparatus, as in Claims 4 or 5, wherein the modulation signal is fed back through the first network to the diode.

7. Amplifier apparatus, as in Claims 2 to 6, wherein the amplifier stage comprises a transistor having its emitter connected to an input terminal of the amplifier, its base connected to ground and its collector connected to an output terminal of the amplifier, the transistor also having an inductor connected between the emitter of the transistor and ground.

8. Amplifier apparatus, as in Claim 7, wherein the modulation signal is applied to the collector of the transistor.

9. Amplifier apparatus, as in Claims 2 or 3, wherein an independent signal is used to control the operation of the diode.

10. Amplifier apparatus, as in Claims 7 to 9, wherein the first network comprises an inductor arranged to inhibit the pulsed signal impinging on the collector of the transistor.

11. Amplifier apparatus, as in Claims 2 to 11, including a second network connected to the other terminal of the diode, wherein the second network is arranged to ensure substantially asymmetric attenuation characteristics of the diode during rising and falling portions of the pulsed signal.

12. Amplifier apparatus, as in Claim 11, wherein the second network comprises a capacitor arranged to charge during a rising portion of the pulsed signal.

13. Amplifier apparatus, as in Claim 12, wherein a resistor is arranged in parallel with the capacitor, the resistor being arranged to ensure discharge of the capacitor at the end of each cycle of the pulsed signal.

14. Amplifier apparatus, as in Claims 12 to 14, wherein the second network also comprises an inductor arranged to inhibit the pulsed signal from impinging on the capacitor.

15. Amplifier apparatus, as in Claims 11 to 14, wherein the first network comprises a first blocking capacitor arranged in series with the diode and the second network comprises a second blocking capacitor arranged in series with the diode, the first and second blocking capacitors being arranged to isolate the diode from the amplifier stage during direct current or for frequencies below a predefined threshold frequency of the pulsed signal.

16. Amplifier apparatus, as in Claims 2 to 15, wherein the pulsed signal is a radio frequency signal.

17. Amplifier apparatus substantially as illustrated in and/or described with reference to the accompanying drawings.

18. An attenuator substantially as illustrated in and/or described with reference to the accompanying drawings.

19. A communications system, having at least one remote unit and at least one base station arranged to communicate with each remote unit over a communication channel, the communication system comprising an attenuator according to Claims 1 or 18.

20. A communications system, having at least one remote unit and at least one base station arranged to communicate with each remote unit over a communication channel, the communications system comprising amplifier apparatus according to Claims 2 to 17.
